(19) Europäisches Patentamt
European Patent Office
Office européen des brevets

(11) **EP 4 109 527 A1**

(12) **EUROPEAN PATENT APPLICATION**

(43) Date of publication:
**28.12.2022   Bulletin 2022/52**

(21) Application number: **21305883.7**

(22) Date of filing: **25.06.2021**

(51) International Patent Classification (IPC):
**H01L 25/075** (2006.01)      **H01L 33/64** (2010.01)

(52) Cooperative Patent Classification (CPC):
**H01L 25/0753; H01L 33/641; H01L 33/644;**
**H01L 33/648;** H01L 33/505

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **Centre national de la recherche scientifique**
  **75016 Paris (FR)**
• **Université Paris-Saclay**
  **91190 Gif-sur-Yvette (FR)**

• **Institut Optique Theorique Appliquee**
  **91127 Palaiseau Cedex (FR)**

(72) Inventors:
• **BALEMBOIS, François**
  **91870 BOISSY LE SEC (FR)**
• **PICHON, Pierre**
  **91120 PALAISEAU (FR)**

(74) Representative: **Atout PI Laplace**
**Immeuble "Visium"**
**22, avenue Aristide Briand**
**94117 Arcueil Cedex (FR)**

(54) **LIGHT EMITTING DEVICE COMPRISING A COOLING SYSTEM**

(57)     A light emitting device (1) comprising:
- a plurality of light emitting diodes (LED) configured to emit an incident light (Ld);
- a solid luminescent concentrator (CL) of index $n_c$ comprising two parallel faces, called large faces (FE1, FE2), along an horizontal plane $xy$, and $n \in \mathbb{N} > 2$ faces called side faces (FL1, FL2, FL3, F4), , at least one of the first and the second large face being illuminated by said incident light (Ld), said concentrator being configured to absorb said incident light (Ld) and then emit a luminescent light ($L_L$), a portion of the luminescent light being guided by total internal reflection (Lg) in the con-

centrator and passing through a first so-called exit face of said concentrator (FL1) in contact with an exit medium (EM) of index $n_s < n_c$, and forming an exit beam ($L_s$),
- a so-called cooling system (CS) comprising a cooling medium (CM) in contact with at least one of the faces of the concentrator, called cooled face (FE1), the cooling system being adapted to remove at least a portion of a heat generated within said concentrator by said plurality of light-emitting diodes, an index $n_{ext}$ of the cooling medium being such that $n_c > n_{ext} > 1$ and adapted to the index of the exit medium and the index of the concentrator to limit the loss in light extraction efficiency of the exit beam induced by the cooling medium.

[Fig.2A]

FIG.2A

**Description**

**Technical field:**

The present invention concerns the field of luminescent light concentrator, and more particularly to concentrator comprising a cooling system.

**Prior Art:**

Light-emitting diodes (LEDs) have many applications in the field of lighting. However, the luminance of LEDs is limited to values that are not suitable for some applications.

One solution to increase the luminance of LEDs is to use LED-pumped luminescent concentrators (see for example Barbet, Adrien, et al. "Light-emitting diode pumped luminescent concentrators: a new opportunity for low-cost solid-state lasers." Optica 3.5 (2016): 465-468.). This concentrator is, for example, a crystal that emit fluorescent light in the visible (red-orange) range, such as Ce:YAG, which absorbs in the blue range (around 450 nm), at a wavelength where LEDs are very efficient. The crystal is cut in the form of a plane, lined by hundreds (even thousands) of LEDs on both large surfaces and with an emission by the edges. These concentrators can achieve luminance values 10 to 20 times higher than that of an LED.

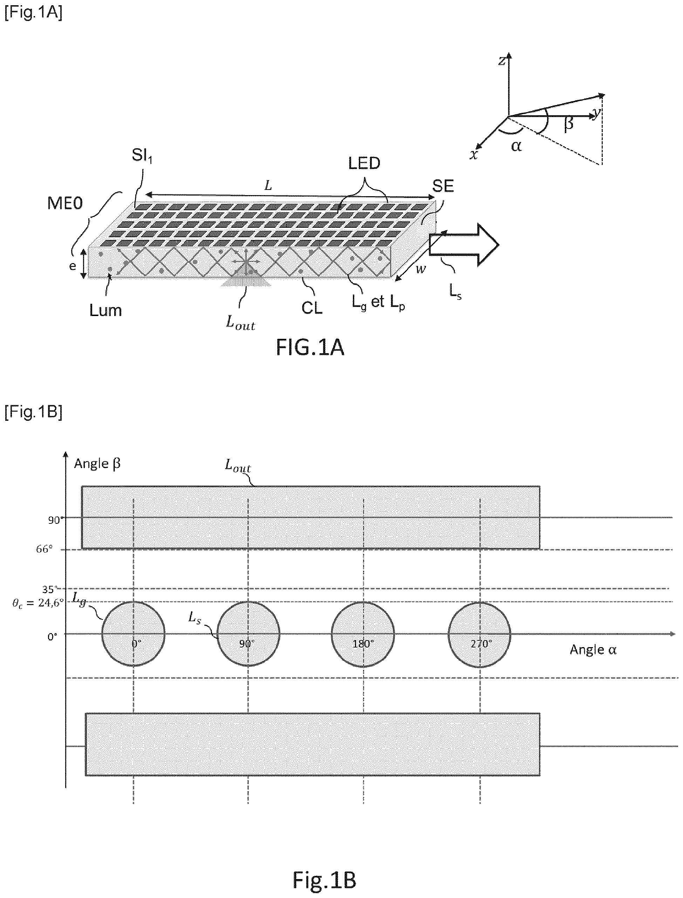

Figure 1A illustrates an example of a light emitting module ME0 known in the prior art based on a concentrator crystal CL. Figures 1A schematically represents a perspective view of the emission module ME0. The emission module ME0 comprises a set of LEDs emitting in a first spectral band, and a light concentrator CL. The concentrator CL is a fluorescent parallelepiped crystal, having at least one illumination face SI1, SI2, of dimensions $L \times w$, illuminated by the electroluminescent radiation Ld emitted by the LEDs. The illumination faces SI1, SI2 are also called "large faces". The other 4 faces are called lateral faces.

The crystal of the concentrator is configured to absorb the electroluminescent radiation Ld. The luminous flux emitted by the LEDs and directed towards the illumination face is absorbed by the luminophores Lum of the fluorescent crystal which are distributed throughout the volume of the crystal and which then emit fluorescence radiation inside the crystal. The emitted rays of the fluorescence radiation can be classified in two main categories:

- trapped rays noted Lp: these rays are trapped in the crystal due to the total internal reflection (TIR) on the different faces of the crystal. These rays exist if the crystal is a parallelepiped with 6 faces parallel two by two. The trapped rays never leave the crystal.

- the untrapped rays are the rays that eventually leave the crystal. They can be separated into two sub-categories: guided rays Lg, which are guided by TIR on the faces of the concentrator and then emerge on one of the faces of the concentrator, and unguided rays $L_{out}$, which emerge directly from the concentrator without being reflected on the faces. The rays that pass through the side face SE forms the exit beam $L_s$.

Figure 1B is a planar representation of the escape cones $L_g$, and $L_{out}$ using angular coordinates ($\alpha$, $\beta$) in the xyz frame of reference : $\beta$ is the angle with respect to the Oz axis. $\alpha$ is the angle in the xy plane, with respect to the Ox axis. The lighter area in between the cones corresponds to the trapped rays $L_p$. This representation is given as an example, with respect to the prior art crystal of figure 1A, with a diamond crystal (refractive index n=2.4). For diamond, given the Snell-Descartes law, the critical angle is $\theta_c$ = 24,6° assuming the ambient medium is air. From figure 1B, one can see the 4 escape cones corresponding to the angles of the rays $L_g$ guided by TIR and escaping through the 4 side faces. The escape cone corresponding to the ray forming the exit beam $L_s$ is the second one to the left. The percentage of radiation trapped by TIR compared to the untrapped radiation is fixed by the index of the crystal and that of the ambient medium, by the Snell-Descartes law. For a parallelepiped concentrator made out of diamond (n=2.4) in ambient air, the percentage of trapped ray is 73%.

In concentrator crystals, the power of the exit beam can be increased via the increase of the pump power. However the pump power is limited by the difficulty to cool a concentrator. The total internal reflection (TIR) on the guiding faces is very sensitive to contact with materials of higher index than air. TIR can be very easily frustrated, inducing light leakage from faces other than the exit face thus reducing the light extraction efficiency of the exit beam $L_s$. The first strategy to limit this problem is to operate the pump LED in quasi-continuous wave : the peak power can be increased whereas the average pump power is maintained at a low level compatible with passive cooling of the concentrator (A. BARBET, et al . "LED pumped luminescent concentrators: a new opportunity for low cost solid-state lasers" Optica, Vol. 3, N°5, pp.465-468 (April 2016).

For high average pump power in quasi-continuous operation or for continuous wave operation, the simplest solution, is to cool the concentrator with air (D. K. G. de Boer, et al. High-brightness source based on luminescent concentration. Optics Express, vol. 24, no. 14, page A1069, July 2016.). In Sathian, J. et al. "Solid-state source of intense yellow light based on a Ce:YAG luminescent concentrator." Optics Express, vol. 25, no. 12, page 13714, June 2017, the concentrator is cooled using two copper blocks while avoiding optical contact with the concentrator. In Christoph Hoelen, et al. "Progress in extremely high brightness LED-based light sources" Sixteenth International Conference on Solid State Lighting and LED-based Illumination Systems, Proc. of SPIE Vol. 10378, 103780N, the concentrator is cooled by a mechanical contact in the form of tips on the two largest lateral faces of the concentrator. As the side faces are less stressed by the total internal reflection, it is consistent that the contact induced losses (losses announced at 1-2%) are quite low. It should be noted, however, that the pump power used in this setup remains moderate, and the cooling capacity of the setup is low. Likewise, CA 2929118 features cooling by mechanical parts positioned near the concentrator ("within 30μm" on the hub, "within 10μm but more than 1μm" on the output guide).

However, all these methods are quite inefficient to remove the heat in the crystal and are not adapted to a high input power (eg pumping the crystal with thousands of LED each emitting at the watt level).

To avoid the frustration of the total internal reflection, one solution is to place a mirror on the guide faces of the concentrator. Contact cooling is then possible behind the reflecting surface, without changing the reflectivity of the surface. For example, Juna Sathian, et al. "Enhancing Performance of Ce:YAG Luminescent Concentrators for High Power Applications" CLEO Europe 2019 paper CD'-P.2 (2019)) use this type of cooling on a large face of a Ce:YAG concentrator covered with a dielectric mirror, in contact with a copper radiator. The reflectivity obtained by this treatment is less efficient than the total internal reflection: in the case of an exit face in the air, the induced losses are moderate (6%). This method allows to limit the heating of the Ce:YAG to a temperature difference of 10° for a pump power of 22 W while the temperature rise reaches 90° when the crystal is not cooled. However, the large face covered by the mirror becomes only functionalized for cooling and guiding the emitted beams. We lose the possibility to pump this functionalized face thus leading to a decrease of the potential pump power by 50%.

The invention aims to alleviate certain problems of the prior art. To this end, an object of the invention is a light emitting device comprising a solid parallelepiped luminescent crystal pumped by a plurality of light emitting diodes wherein one of the faces of the concentrator is in contact with a cooling medium adapted to remove at least a portion of a heat generated within said concentrator by the plurality of light-emitting diodes, an index $n_{ext} > 1$ of the cooling medium being adapted to the index of the exit medium and the index of the concentrator to limit the loss in light extraction efficiency of the exit beam induced by the cooling medium. In the invention, the crystal can thus be cooled efficiently by an optical contact with a cooling medium of controlled index without no or minimal effect on the light extraction efficiency of the concentrator.

### Summary of the invention :

To this end, an object of the invention is a light emitting device comprising:

- a plurality of light emitting diodes configured to emit an incident light;

- a solid luminescent light-concentrator of index $n_c$ comprising two parallel faces, called first and second large faces, along an horizontal plane $xy$, and $n \in \mathbb{N} > 2$ faces called side faces , at least one of the first and the second large face being illuminated by said incident light, said concentrator being configured to absorb said incident light and then emit a luminescent light, a portion of the luminescent light being guided by total internal reflection (Lg) in the concentrator and passes through a first so-called exit face of said concentrator in contact with an exit medium of index $n_s < n_c$, and forms an exit beam,

- a so-called cooling system comprising a cooling medium in contact with at least one of the faces of the concentrator, called cooled face, the cooling system being adapted to remove at least a portion of a heat generated within said concentrator by said plurality of light-emitting diodes, an index $n_{ext}$ of the cooling medium being such that $n_c > n_{ext} > 1$ and adapted to the index of the exit medium and the index of the concentrator to limit the loss in light extraction efficiency of the exit beam induced by the cooling medium.

In a preferred embodiment of the invention, the index of the cooling medium is such that the loss in light extraction efficiency of the exit beam is lower or equal to 15%.

In a preferred embodiment of the invention, the index of the cooling medium is such that

$$n_{ext} \leq \frac{n_s}{\tan(\sin^{-1}(\frac{n_S}{n_c}))}.$$

In a preferred embodiment of the invention, the cooling medium is in contact with at least 90% of said cooled face.

In a variant of the invention, the cooling medium is in contact with the first and the second large faces.

In an embodiment of the invention, the cooling system comprises a layer in a heat conducting material that conducts the heat to mechanical radiators, said layer forming the cooling medium.

In an embodiment of the invention the cooling medium is water.

In an embodiment of the invention the cooling system comprises a holder adapted to support the concentrator and the plurality of light emitting diodes, a channel connected to a water supply, the channel being adapted to transport said water, the holder comprising sealing elements adapted to ensure the sealing of the device.

In a preferred embodiment of the invention, the device comprises a mirror covering a face of the concentrator opposite to the exit face.

In an embodiment of the invention, the device comprises an additional solid luminescent light concentrator, said exit beam pumping the additional concentrator via a so called receiving face of the additional concentrator, in contact with the exit medium, wherein the additional concentrator is adapted to absorb the exit beam and then emit an additional luminescent radiation, wherein a portion of the additional luminescent radiation passes through a so-called additional exit face of the additional concentrator and forms an exit beam, wherein the additional exit face is in contact with an additional exit medium of index $n'_s$, wherein the index $n_s$ of the exit medium is adapted to the index of the additional concentrator and the index $n'_s$ of the additional exit medium to achieve the highest extraction efficiency possible of the additional exit beam.

**Brief description of the drawings** :

Other features, details and advantages of the invention will become apparent from the description made with reference to the annexed drawings, which are given as examples and which represent, respectively:

[Fig.1A], a light emitting module known in the prior art based on a concentrator crystal,

[Fig.1B], a planar representation of the escape cones $L_g$, and $L_{out}$ of the light emitting module of the prior art,

[Fig.2A], a light emission device according to the invention,

[Fig.2B] a representation of the escape cones associated to the rays $L_g$, $L_s$, $L_{out,1}$ and $L_{out,2}$, of the light emission device according to the invention,

[Fig.2C], a planar representation of the escape cones of the rays $L_g$, $L_s$, $L_{out,1}$ and $L_{out,2}$ of the device according to the second embodiment,

[Fig.2D], a planar representation of the escape cones of the rays $L_g$, $L_s$, $L_{out,1}$ and $L_{out,2}$ of the device according to the third embodiment,

Fig.3A], a light emission device according to a variant of the invention,

[Fig.3B], a planar representation of the escape cones of the rays $L_g$, $L_s$, $L_{out,1}$ and $L_{out,2}$ of the device according to a variant of the invention,

[Fig.4], a planar representation of the escape cones of the rays $L_g$, $L_s$, $L_{out,1}$ and $L_{out,2}$ of the device according to the fourth embodiment,

[Fig.5], a planar representation of the escape cones of the rays $L_g$, $L_s$, $L_{out,1}$ and $L_{out,2}$ of the device according to the embodiment,

[Fig.6A], [Fig.6B], [Fig.6C], a perspective view, a profile view according to section A-B and profile view according to section C-D respectively, of a light emitting device according to another embodiment of the invention,

[Fig.7], a light emitting device according to another embodiment of the invention,

[Fig.8], a light emitting device according to another embodiment of the invention wherein the device comprises a cascade of two luminescent concentrators CL, CL'.

In the drawings, unless otherwise indicated, the elements are not to scale.

**Detailed specification** :

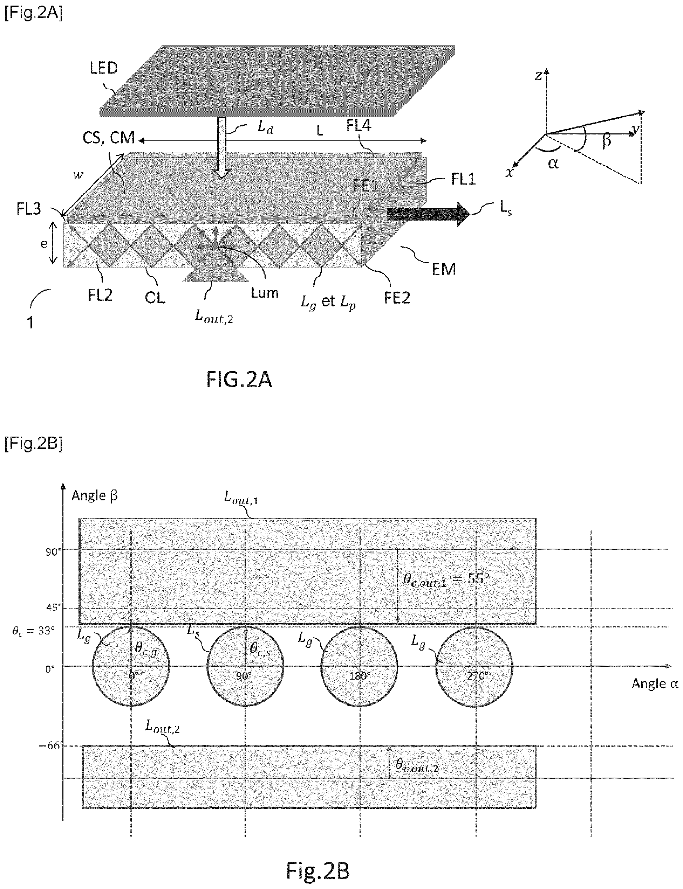

Figure 2A illustrates a light emission device 1 according to the invention. The device 1 of the invention comprises a plurality of light emitting diodes LED configured to emit an incident light Ld.

To increase the luminance of the light emitting diodes LED, the device of the invention comprises a solid luminescent light-concentrator CL of index $n_c$ comprising two parallel faces, called first and second large faces FE1, FE2, along an horizontal plane *xy,* and $n \in \mathbb{N} > 2$ faces called side faces FL1, FL2, FL3, F4. Given as an illustrative example in figure 2A, the concentrator CL is a rectangular parallelepiped with a thickness *e* and has a first and a second large face FE1, FE2 of dimensions $L \times w$ in a horizontal plane *xy.*

The light emitting diodes LED pump the concentrator CL via at least one of the first and the second large face illuminated by the incident light Ld. The incident light Ld is absorbed by the luminophores Lum of the luminescent concentrator CL which are distributed throughout the volume of the crystal and which then emit a luminescent light $L_L$ inside the crystal.

According to one embodiment, the concentrator is a crystal, like Ce:YAG or Ce:LYSO. In another embodiment, the light concentrator is not a crystal but another material, like glass or PMMA doped by luminophores.

As known to one skilled in the art, a portion, called trapped portion Lp, of said luminescent light is trapped by total internal reflection in said concentrator. As previously stated, the ratio of trapped and untrapped rays is fixed by the index of the concentrator and the index of the ambient medium, by the Snell-Descartes law. Trapped rays are noted Lp and can never leave the concentrator due to the TIR on the different faces of the concentrator. The untrapped rays are the rays that eventually leave the concentrator. They can be separated into two sub-categories: guided rays Lg, which are guided by TIR on the large faces or side faces and emerge on one of the faces of the concentrator; and unguided rays $L_{out,1}$ and $L_{out,2}$ which emerge directly from the face FE1 and FE2 of the concentrator respectively, without being reflected on the faces.

A portion $L_s$ of the guided rays $L_g$ passes through a first so-called exit face FL1 of the concentrator in contact with an exit medium EM of index $n_s < n_c$, and forms an exit beam $L_s$. Given as an illustrative example, in figure 2A, the exit face FL1 has dimensions $e \times w$. In another embodiment, the exit face is formed by another side face, for example side face FL2, with dimension $L \times w.$

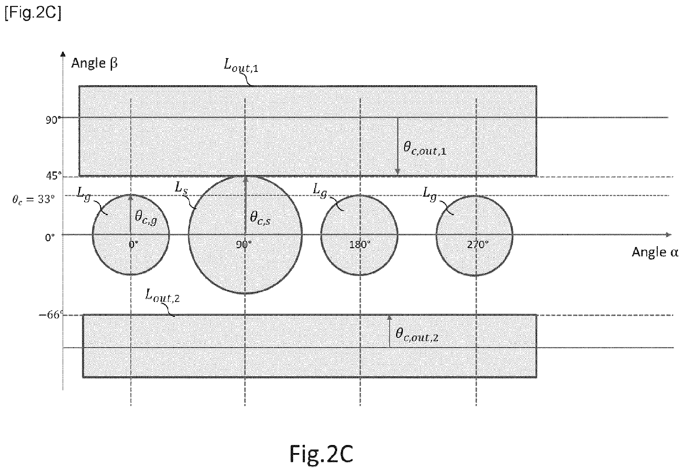

According to one embodiment of the invention, the exit medium is air (see figure 2B for example). In another embodiment, to increase the light extraction efficiency of the exit beam, the exit medium has an index $n_s > 1$ (see figure 2C for example).

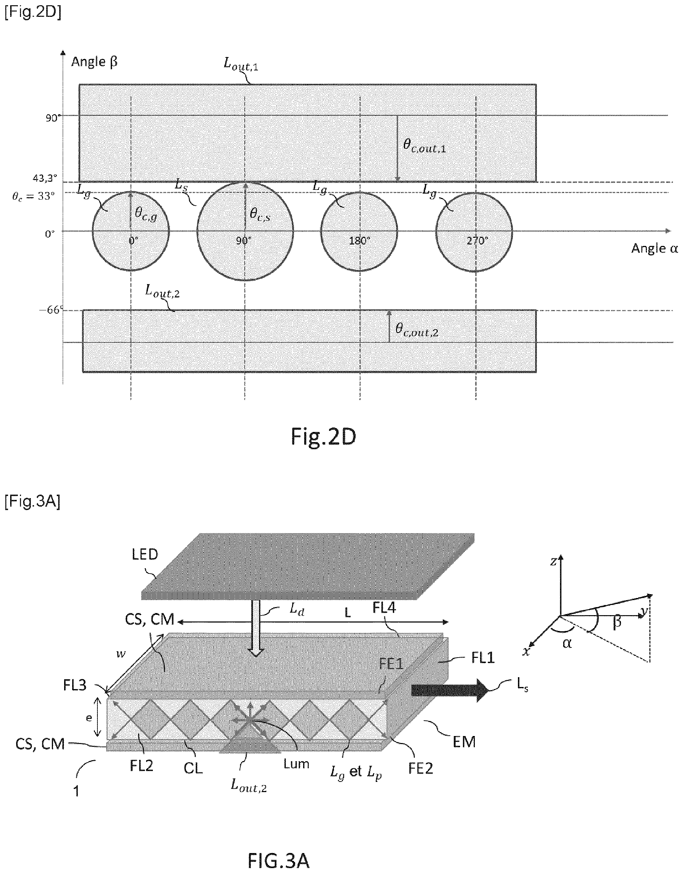

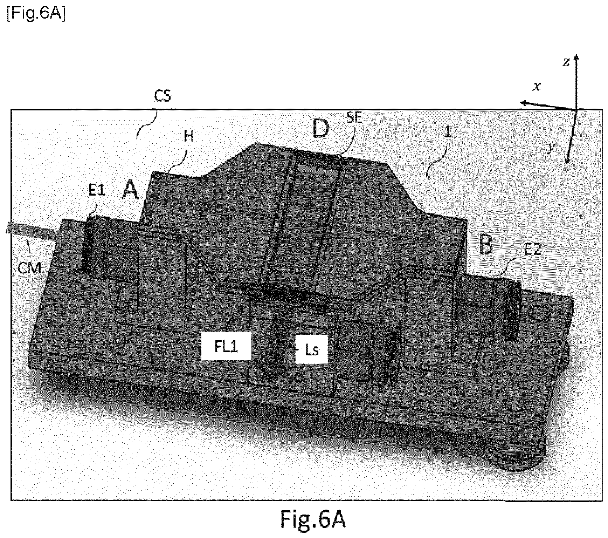

The device of the invention comprises a so-called cooling system CS comprising a cooling medium CM in contact with at least one of the faces of the concentrator (called hereinafter "cooled face"). The cooling system is adapted to remove at least a portion of the heat generated within the concentrator CL by the plurality of light-emitting diodes LED. The index $n_{ext}$ of the cooling medium is such that $n_c > n_{ext} > 1$ to allow a thermal conductivity higher than air. Unlike light emitting devices of the prior art, the cooling medium is in uniform contact with the majority of the surface of the cooled face FE1. More precisely, the cooling medium is in contact with more than 90% of the cooled face. This allows for a much more efficient cooling of the pump power compared to prior art configurations using only a single point of contact with the cooled face. Given as an illustrative example, in figure 2A, the only cooled face is large face FE1. In another embodiment of the invention, to increase the heat removed by the cooling system, more faces of the concentrator CL are in contact with the cooling medium, for example FE1 and FE2 (see for example figure 3A), or FE1, FE2, FL2 and FL4 (see for example figures 6A-6C). Thus, more LEDs and more pump power can be used.

The cooling system CS can remove the heat while preserving the total internal reflection of the light $L_s$ guided in the concentrator and passing through the exit face FE1. More precisely, the index $n_{ext}$ of the cooling medium CM is adapted to the index of the exit medium $n_s$ and the index of the concentrator $n_c$ to limit the loss in light extraction efficiency of the exit beam $L_s$ induced by the cooling medium CM. Indeed, as previously stated, the total internal reflection on the guiding faces of the concentrator CL is very sensitive to contact with materials of higher index than air. Thus, if $n_{ext}$ is not carefully chosen, the presence of the cooling medium in contact with the cooled face FE1 can induce an important light leakage from faces other than the exit face reducing the light extraction efficiency of the exit beam $L_s$.

Preferably, the index of the cooling medium is such that the cooling medium induces no loss in the light extraction efficiency of the exit beam (see eg: figures 2B to 4).

In the embodiment illustrated in figure 2A, the face of the concentrator pumped by the diodes LED is the same as the face in contact with the cooling medium, FE1. Therefore, in this embodiment, it is necessary that the cooling medium CM is transparent to the incident light emitted by the LEDs. More generally, when the cooling medium covers a face that is pumped by the LEDs, the cooling is transparent to the light emitted by the LEDs

In order to better understand the influence of the cooling medium on the extraction efficiency, figure 2B illustrates a representation of the escape cones associated to the rays $L_g$, $L_s$, $L_{out,1}$ and $L_{out,2}$ using angular coordinates $(\alpha, \beta)$ in the *xyz* frame of reference of figure 2A. The lighter area in between the cones corresponds to the trapped rays $L_p$.

As an example, the representation of figure 2B is given with respect to the concentrator of the invention illustrated in figure 2A, with a cooling medium of index $n_{ext}$ = 1.5 and an exit medium $n_s$ = 1 (air). Thus, the faces other than the cooled face are in ambient air. We call this embodiment of the invention, first embodiment M1. As an example, the concentrator CL is a Ce:YAG crystal of index $n_c$ = 1.83.

The escape cones of figure 2B denoted 0°, 180° and 270° corresponds to the range of angles of guided rays $L_g$ that exits the sides faces FL2, FL4 and FL3 respectively. We call $\theta_{c,g}$ the critical angle of these escape cones. The escape cones associated to the rays $L_s$ forming the exit beam is denoted 90° in figure 2B. We call $\theta_{c,s}$ the critical angle of this escape cone. Given the indexes and the geometry of this embodiment M1, the critical angle of the TIR on the faces FL1, FL2, FL3, FL4 and FE2 of the concentrator in contact with air is $\theta_{c,g} = \theta_{c,s} = \sin^{-1}(\frac{n_s}{n_c}) = \sin^{-1}(\frac{1}{1.83}) = 33°.$ Rays propagating inside the concentrator with an angle higher or equal than that critical angle, with respect to the normal of those faces, are trapped within the concentrator CL. As can be seen in figure 2B, the critical angle $\theta_{c,out1} = \sin^{-1}(\frac{n_{ext}}{n_c}) = 55°$ of the escape cone of the rays $L_{out,1}$ associated to the cooled face FE1 is greater than the critical angle $\theta_{c,out2} = \theta_{c,g}$ = 33° of the escape cone of the rays $L_{out,2}$ associated to the large face FE2. This is because the cooling medium CM in contact with the cooled face FE1 has an index $n_{ext}$ such that $n_c > n_{ext} > 1$ and thus greater than the index of air which is the medium in contact with face FE2.

To ensure that the cooling medium CM does not induce a loss in light extraction efficiency of the exit beam $L_s$, it is necessary that there is no overlap between the range of angles of the rays $L_{out,1}$ and the range of angles of the rays $L_s$. In the configuration illustrated in figure 2B, given the Snell-Descartes law, there will be no overlap, as long as:

$$n_{ext} \leq n_c.sin(90° - \theta_{c,s}) \ (EQ0).$$

In embodiment M1, given $\theta_{c,s}$ = 33° and $n_c$ = 1.83, this means that there will be no overlap as long as $n_{ext} \leq$ 1.53. As $n_{ext}$ = 1.5 in the embodiment M1, there is no overlap between the range of angles of the rays $L_{out,1}$ and the range of angles of the rays $L_s$.

EQ0 implies that it is possible to use water as a cooling medium without inducing a loss in light extraction efficiency of the exit beam $L_s$. Therefore, in an embodiment of the invention, the cooling medium is water ($n_{ext}$ = 1.333), the concentrator is in Ce:YAG and all the faces other than the cooled face FE1 are in contact with air. In this embodiment, the medium CM does not induce a loss in the light extraction efficiency of the exit beam $L_s$ because $n_{ext} \leq$ 1.53. For this embodiment as well, the share of luminescent light exiting the exit face FL1 (ie: the light extraction efficiency) is 8% of the total luminescent light emitted by the concentrator.

The use of water to cool the concentrator CL is advantageous because this type of cooling can be shared with the LEDs. Indeed, as the efficiency of LEDs is about 30%, it is necessary to evacuate a large part of the power (at the kW level if thousands of LEDs are used). Therefore, in a preferred embodiment of the invention, the number of light emitting diodes LED pumping the concentrator CL comprised in the device 1 is greater or equal to a thousand, the cooling medium is water, and the cooling system is adapted to cool both the concentrator CL and the LED with said water.

The device of the invention can therefore use a cooling medium with higher thermal conductivity than air (like water) to remove efficiently the heat generated in the concentrator CL by the LEDs, without inducing a loss in the light extraction efficiency of the exit beam $L_s$.

In the embodiment illustrated in figure 2A, only the large face FE1 is pumped. In another embodiment, to achieve a higher pump power and therefore a higher power of the exit beam $L_s$, both of the large faces FE1 and FE2 are pumped by LEDs.

To achieve a higher light extraction efficiency of the exit beam, in a second embodiment M2 of the invention, the exit medium has an index $n_s$ higher than air ($n_s$ > 1) and equal to the index $n_{ext}$ of the cooling medium ($n_s = n_{ext}$). For example, the exit medium can be a glue, or water. Figure 2C which shows a planar representation of the escape cones of the rays $L_g$, $L_s$, $L_{out,1}$ and $L_{out,2}$ of the second embodiment M2, using the same angular coordinates $(\alpha, \beta)$ as figure 2B. Like in the representation of figure 2B, as an example, the representation of figure 2C is given with respect to the concentrator of the invention illustrated in figure 2A, with a Ce:YAG crystal of index $n_c$ = 1.83. The faces other than the cooled face and the exit face are in air. To achieve the highest lossless extraction efficiency of the $L_s$ beam possible given an index $n_c$, it is necessary that $n_s = n_{ext} = n_c.sin(45°) = \frac{n_c}{\sqrt{2}} = 1.29$. By lossless, it is meant that there is no light leakage of rays $L_s$ through the cooled face or any face other than the exit face before passing through the exit face FL1. That is because $\theta_{c,s} = \theta_{c,out1} = 45°$ and thus, there is no overlap between the range of angles of the rays $L_{out,1}$ exiting the cooled face FE1 and the rays $L_s$ exiting the exit face FL1. Using an exit medium with the same index $n_s$ as the cooling medium, we have increased the light extraction efficiency of the exit beam from 8% in the embodiment M2 to 14.5% in the embodiment M2, while maintaining a lossless extraction.

In a third embodiment M3 of the invention, the exit medium has an index $n_s$ different to the index $n_{ext}$ of the cooling medium ($n_s \neq n_{ext}$). This can be interesting to achieve a higher light extraction efficiency of the exit beam $L_s$ than in the embodiment M2 in which $n_s = n_{ext}$, by using $n_s > n_{ext}$. Or it can be advantageous to use a specific cooling medium (eg: water) no suited for the exit medium. For a given index $n_s$ of exit medium, to ensure a lossless extraction efficiency, it is necessary that:

$$\theta_{c,s} + \theta_{c,out1} \leq 90°$$

Which gives :

$$\sin^{-1}(n_s/n_c) + \sin^{-1}(n_{ext}/n_c) \leq 90°$$

Which gives the following condition on the index of the cooling medium:

$$n_{ext} \leq n_c.\cos(\sin^{-1}\left(\frac{n_s}{n_c}\right)), \ (EQ1),$$

equivalent to

$$n_{ext} \leq \frac{n_s}{\tan(\sin^{-1}\left(\frac{n_s}{n_c}\right))} \ (EQ1')$$

In this embodiment M3, a higher extraction efficiency of the $L_s$ beam is achievable than the embodiment M1 that uses air as an exit medium, while still achieving a lossless extraction efficiency of the $L_s$ beam. In this embodiment, a cooling medium with higher thermal conductivity than air can be used to remove the heat generated in the concentrator CL by the LEDs, while achieving a high and lossless light extraction efficiency. Figure 2D shows a planar representation of the escape cones of the rays $L_g$, $L_s$, $L_{out,1}$ and $L_{out,2}$ of this embodiment, using the same angular coordinates ($\alpha$, $\beta$) as figure 2B. In the illustration of figure 2D given as an example, the cooling medium is water ($n_{ext} = 1.33$, $\theta_{c,out,1} = 46,6°$) and the concentrator CL is a Ce:YAG crystal of index $n_c = 1.83$. The exit medium has a refractive index of $n_s = 1.22$. The faces other than the cooled face and the exit face are in air.

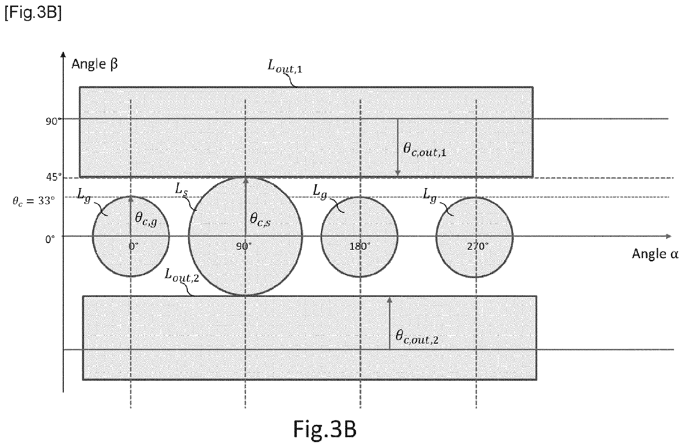

To achieve a better removal of the heat generated in the concentrator CL, in a variant of the embodiment illustrated in figure 3A, the second large face FE2 is also in contact with the cooling medium CM. Thus, more LEDs and more pump power can be used, and an exit beam with more power can be achieved. Figure 3B shows a planar representation of the escape cones of the rays $L_g$, $L_s$, $L_{out,1}$ and $L_{out,2}$ of this variant, using the same angular coordinates ($\alpha,\beta$) as figure 2B. In the illustration of figure 3B given as an example, $n_s = n_{ext} = 1.29$ and the concentrator CL is a Ce:YAG crystal of index $n_c = 1.83$. The faces other than the cooled face and the exit face are in air. Because the second large face FE2 is also in contact with the cooling medium CM, one can see from figure 3B that the critical angle $\theta_{c,out1} = 33°$ of the escape cone of the rays $L_{out,1}$ associated to the cooled face FE1 is equal to the critical angle $\theta_{c,out2} = 33°$ of the escape cone of the rays $L_{out,2}$ associated to the other cooled face FE2. Because the index of the cooling medium was chosen appropriately with respect to the index of the exit medium and the index of the concentrator

$$(n_s = n_{ext} = n_c.sin(45°) = \frac{n_c}{\sqrt{2}} = 1.29),$$
there is no overlap between the range of angles of the rays exiting the cooled faces FE1 and FE2 and the range of angles of the rays $L_s$. Thus, the light extraction efficiency of the exit beam $L_s$ is lossless.

To increase the extraction efficiency of the $L_s$ beam, in an embodiment of the invention, compatible with all the previously mentioned embodiments of the invention, the device comprises a mirror covering the face of the concentrator opposite to the exit face FL1. Thus, all the rays forming the escape cone of the face FL3 are reflected in the concentrator CL and then exit through the exit face and contribute to the power of the exit beam $L_s$ instead of exiting through FL3. As an example, in the embodiment of figure 2B, a mirror covering the face of the concentrator opposite to the exit face FL1 doubles the extraction efficiency of the $L_s$ beam from 8% to $2 \times 8\% = 16\%$, assuming the mirror has reflection coefficient of 1 and not taking into account propagation losses due to absorption inside the concentrator CL.

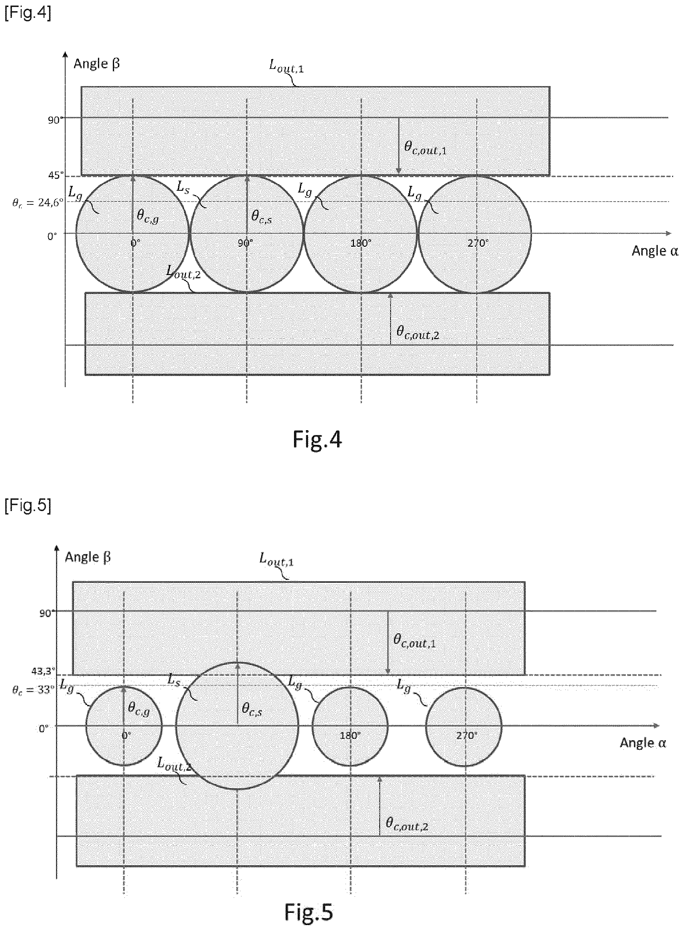

To achieve the best heat removal possible, in a fourth embodiment M4 of the invention, all the faces of the concentrator CL including the exit face FL1 are in contact with the cooling medium. This implies that $n_s = n_{ext}$. Figure 4 shows a planar representation of the escape cones of the rays $L_g$, $L_s$, $L_{out,1}$ and $L_{out,2}$ of this fourth embodiment M4, using the same angular coordinates $(\alpha, \beta)$ as figure 2B. In the illustration of figure 4, given as an example,

$$n_s = n_{ext} = \frac{n_c}{\sqrt{2}} = 1.29$$ and the concentrator CL is a Ce:YAG crystal of index $n_c = 1.83$. As seen in figure 4, those indexes imply that the critical angle associated with every escape cones of the rays $L_g$, $L_s$, $L_{out,1}$ and $L_{out,2}$ is equal to

$$\sin^{-1}\left(\frac{1.29}{1.83}\right) = 45°.$$ The highest value of $n_{ext}$ with respect to $n_c$ to ensure the highest lossless light extraction efficiency of the $L_s$ beam possible is calculated from EQ1, assuming $n_s = n_{ext}$. This value is given by $$n_{ext} = \frac{n_c}{\sqrt{2}}.$$

It is understood from the various embodiments, that the index of the exit medium $n_s$ is actually adapted to the index of the concentrator, and to the index of the ambient medium in contact with the other faces (ie: faces other than the exit face an the cooled face(s)) to limit the loss in light extraction efficiency of the exit beam. Indeed, if the index of the ambient medium in contact with the other faces is different to the index of the exit medium, it is possible to have $\theta_{c,s} + \theta_{c,g} > 90°$ and thus have an overlap between the espace cones of the other faces and the escape cone of the exit face. Thus, is a preferred embodiment, the index of the exit medium $n_s$ is such that $\theta_{c,s} + \theta_{c,g} \leq 90°$.

According to fifth embodiment M5 of the invention, the index of the cooling medium CM is such that the loss in light extraction efficiency of the exit beam induced by the cooling medium CM is lower or equal to 15%. Figure 5 shows a planar representation of the escape cones of the rays $L_g$, $L_s$, $L_{out,1}$ and $L_{out,2}$ of this embodiment M5, using the same angular coordinates $(\alpha, \beta)$ as figure 2B. Given as an example, the device is identical to the embodiment of figure 3A, with the cooling medium being water, with the exit medium EM having an index $n_s = 1.5$ and with a Ce:YAG crystal. All the other faces, other than the exit face and the cooled faces, are in air. Given the indexes and the structure of the device, the critical angles associated with the large faces (here both cooled faces) FE1, FE2 are

$$\theta_{c,out,1} = \theta_{c,out,2} = \sin^{-1}\left(\frac{1.333}{1.83}\right) = 46.6°.$$ The escape cones associated with the faces FL2, FL3 and FL4 have a critical angle $\theta_{c,g} = 33°$. Because the exit medium has an index $n_s = 1.5$, the critical angle of the escape cone of the $L_s$ rays is $$\theta_{c,s} = \sin^{-1}\left(\frac{1.5}{1.83}\right) = 55.1°.$$ Thus, $\theta_{c,s} + \theta_{c,out,1} = \theta_{c,s} + \theta_{c,out,2} > 90°$ and there is an overlap between the range of angles of the escape cones of rays $L_{out,1}/L_{out,2}$ and the range of angles of the escape cone of rays $L_s$. This means that rays of the luminescent light within this range of angles will leak out the concentrator through the cooled faces FE1 and FE2 instead of passing through the exit face FL1. This leads to a decrease of the light extraction efficiency of the exit beam $L_s$. With the parameters used for the illustration of figure 5, in the fifth embodiment M5, the overlap induces a loss of 11,5% in light extraction efficiency.

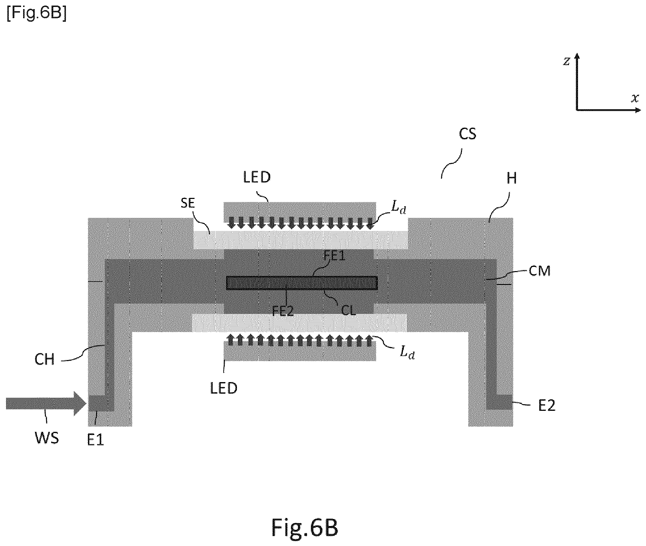

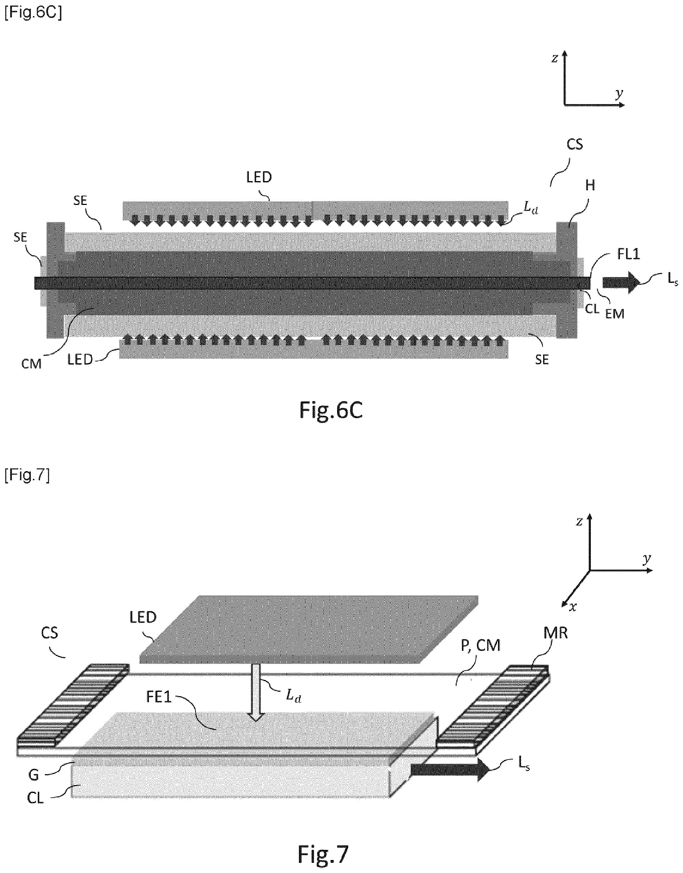

Figure 6A, 6B, 6C illustrate a perspective view, a profile view according to section A-B and profile view according to section C-D respectively, of a light emitting device according to another embodiment of the invention. In this embodiment, the cooling system comprises a holder H adapted to support the concentrator CL and the plurality of light emitting diodes LED. As an example, the holder can be made of metal like aluminum or copper. The holder comprises a channel CH adapted to be connected to a water supply WS (not represented in figure 6A but visible in figure 6B) via one extremity E1. The water flowing in channel CH forms the cooling medium. More precisely, the channel is adapted to transport the water flowing from the water supply from the extremity E1 to the extremity E2 so that the water is in contact with the totality of side face FL2 and FL4 and is in contact with more than 90% of the surface of the faces FE1 and FE2 illuminated by the incident light $L_d$. The holder comprises sealing elements SE adapted to ensure the sealing of the device 1. The sealing elements in the direct path of the incident light $L_d$ are transparent to said incident light. Because water flowing in the channel CH is in contact with the majority of the surface of the concentrator CL, the embodiment of figure 6A is suitable to remove heat in the concentrator generated by pump power of high value (eg: for several thousands of light emitting diodes). For a concentrator with dimensions 105 $mm \times 22$ $mm \times 1mm$, with a water flux of 4L/min and with a temperature difference of 10°C between the water and the concentrator, the light emitting device of figures 6A to 6C, via the cooling medium, can extract up to 185.4W of thermal power. This calculation was made using finite element analysis. As a comparison, if the only cooled faces are the faces FE1, FE2, 177.3 W of thermal power can be extracted. This shows that the large faces are much more efficient in cooling the concentrator. If the cooling medium was air in the device of figures 6A to 6C, only 12.3 W of thermal power could be extracted.

Figure 7 illustrates a light emitting device according to another embodiment of the invention. In this embodiment, the cooling system comprises a layer P in a heat conducting material that conducts the heat to mechanical radiators MR. The layer P forms the cooling medium CM. In the embodiment illustrated in figure 7, the face FE1 of the concentrator pumped by the diodes LED is the same as the face in contact with the layer P. Therefore, in this embodiment, it is necessary that the layer is transparent to the incident light emitted by the LEDs. As an example, the layer is in CaF2 or sapphire. Furthermore, preferably, the mechanical radiators MR are located outside the path of the incident light in order not to block said incident light. In the embodiment of figure 7, the device 1 comprises a thin sub-layer G typically optical glue, that binds the layer P to the cooled face FE1. This sub-layer G is optional.

The embodiment of figure 7 is suitable to remove heat in the concentrator generated by pump power of moderate value (eg: for several hundreds of light emitting diodes).

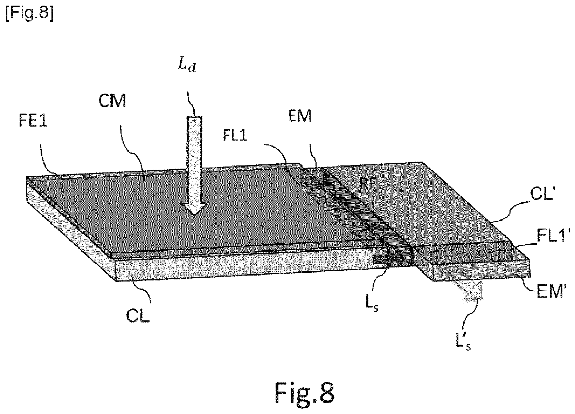

Figure 8 illustrates a light emitting device according to another embodiment of the invention, wherein the device comprises a cascade of two luminescent concentrators CL, CL'. In this embodiment, as an illustrative example, the only cooled face of the concentrator CL is the large face FE1. The exit beam $L_s$ passes through the exit face FL1 of the concentrator CL, in contact with an exit medium EM, before pumping the additional concentrator CL' via a so called receiving face RF also in contact with the exit medium EM. The additional concentrator is adapted to absorb the rays of the exit beam $L_s$ and then emit an additional luminescent radiation. As explained previously, a portion of the additional luminescent radiation passes through a so-called additional exit face FL1' of the additional concentrator and forms an exit beam $L'_s$. The additional exit face FL1' is in contact with an additional exit medium EM' of index $n'_s$. As an example, all the other faces other than the cooled face FE1, the exit face FL1, the additional exit face FL1' and the receiving face RF are in air. In the embodiment of figure 8, the exit medium is adapted to increase the extraction efficiency of the exit beam $L_s$ but also to maintain a mechanical contact between the two concentrators CL and CL'.

Like in all the previous embodiments, in the embodiment of figure 8, the index $n_{ext}$ of the cooling medium is adapted to the index of the exit medium and to the index of the concentrator CL to limit the loss in light extraction efficiency of the exit beam $L_s$ induced by the cooling medium. To achieve the highest extraction efficiency possible of the additional exit beam $L'_s$, the index $n_s$ of the exit medium EM is also adapted to the index of the additional concentrator CL' and the index $n'_s$ of the additional exit medium. More precisely, the index $n_s$ of the exit medium is such that there is no overlap between the escape cone of the additional luminescent light associated to the face FL1' and the escape cone of the additional luminescent light associated to the face RF. Thus, an efficient cascade of luminescent light concentrators is achieved in the embodiment of figure 8.

To increase the light extraction efficiency of the additional exit beam $L'_s$, in a variant of the embodiment of figure 8, mirrors cover the side faces of the additional concentrator other than the additional exit face FL1'.

**Claims**

1. A light emitting device (1) comprising:

  - a plurality of light emitting diodes (LED) configured to emit an incident light (Ld);
  - a solid luminescent light-concentrator (CL) of index $n_c$ comprising two parallel faces, called first and second large faces (FE1, FE2), along an horizontal plane $xy$, and $n \in \mathbb{N} > 2$ faces called side faces (FL1, FL2, FL3, F4), , at least one of the first and the second large face being illuminated by said incident light (Ld), said concentrator being configured to absorb said incident light (Ld) and then emit a luminescent light ($L_L$), a portion of the luminescent light being guided by total internal reflection (Lg) in the concentrator and passes through a first so-called exit face of said concentrator (FL1) in contact with an exit medium (EM) of index $n_s < n_c$, and forms an exit beam ($L_s$),
  - a so-called cooling system (CS) comprising a cooling medium (CM) in contact with at least one of the faces of the concentrator, called cooled face (FE1), the cooling system being adapted to remove at least a portion of a heat generated within said concentrator by said plurality of light-emitting diodes, an index $n_{ext}$ of the cooling medium being such that $n_c > n_{ext} > 1$ and adapted to the index of the exit medium and the index of the concentrator to limit the loss in light extraction efficiency of the exit beam induced by the cooling medium.

2. A device according to claim 1, wherein the index of the cooling medium is such that the loss in light extraction efficiency of the exit beam is lower or equal to 15%.

3. A device according to any of the preceding claims, wherein the index of the cooling medium is such that

$$n_{ext} \leq \frac{n_s}{\tan(\sin^{-1}(\frac{n_s}{n_c}))}.$$

4. A device according to any of the preceding claims, wherein the cooling medium is in contact with at least 90% of said cooled face.

5. A device according to any of the preceding claims, wherein the cooling medium is in contact with the first and the second large faces.

6. A device according to any of the preceding claims, wherein the cooling system comprises a layer (P) in a heat conducting material that conducts the heat to mechanical radiators (MR), said layer forming the cooling medium.

7. A device according to any of the claims 1 to 5, wherein the cooling medium is water.

8. A device according to claim 7, wherein the cooling system comprises a holder (H) adapted to support the concentrator and the plurality of light emitting diodes, a channel (CH) connected to a water supply (WS), the channel being adapted to transport said water, the holder comprising sealing elements (SE) adapted to ensure the sealing of the device.

9. A device according to any of the preceding claims, comprising a mirror covering a face of the concentrator opposite to the exit face.

10. A device according to any of the preceding claims, comprising an additional solid luminescent light concentrator (CL'), said exit beam ($L_s$) pumping the additional concentrator (CL') via a so called receiving face (RF) of the additional concentrator, in contact with the exit medium (EM), wherein the additional concentrator is adapted to absorb the exit beam ($L_s$) and then emit an additional luminescent radiation, wherein a portion of the additional luminescent radiation passes through a so-called additional exit face (FL1') of the additional concentrator and forms an exit beam ($L'_s$,) wherein the additional exit face (FL1') is in contact with an additional exit medium (EM') of index $n'_s$, wherein the index $n_s$ of the exit medium (EM) is adapted to the index of the additional concentrator (CL') and the index $n'_s$ of the additional exit medium (EM') to achieve the highest extraction efficiency possible of the additional exit beam ($L'_s$).

[Fig.1A]

FIG.1A

[Fig.1B]

Fig.1B

[Fig.2A]

FIG.2A

[Fig.2B]

Fig.2B

[Fig.2C]

Fig.2C

[Fig.2D]

Fig.2D

[Fig.3A]

FIG.3A

[Fig.3B]

Fig.3B

[Fig.4]

Fig.4

[Fig.5]

Fig.5

[Fig.6A]

Fig.6A

[Fig.6B]

Fig.6B

[Fig.6C]

Fig.6C

[Fig.7]

Fig.7

[Fig.8]

Fig.8

Europäisches
Patentamt
European
Patent Office
Office européen
des brevets

# EUROPEAN SEARCH REPORT

**Application Number**

**EP 21 30 5883**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/078949 A1 (BECHTEL HANS-HELMUT [DE] ET AL) 26 March 2009 (2009-03-26) * paragraph [0008] * * paragraph [0010] * * paragraph [0013] * * paragraph [0016] - paragraph [0000] * * paragraph [0032] * * paragraph [0045] * * figures 1,2 * | 1-10 | INV. H01L25/075 H01L33/64 |
| A | GB 1 580 564 A (FRAUNHOFER GES FORSCHUNG) 3 December 1980 (1980-12-03) * claims 1-9 * | 1-10 | |
| A | WO 2014/155227 A1 (KONINKL PHILIPS NV [NL]) 2 October 2014 (2014-10-02) * claims 1-14; figures 2-12B * | 1-10 | |
| A | WO 2007/122543 A2 (PHILIPS INTELLECTUAL PROPERTY [DE] ET AL.) 1 November 2007 (2007-11-01) * figures 1-4 * * page 4, line 16 - page 5, line 29 * | 1-10 | TECHNICAL FIELDS SEARCHED (IPC) H01L |
| A | WO 2006/104907 A1 (3M INNOVATIVE PROPERTIES CO [US]) 5 October 2006 (2006-10-05) * pages 10,11; figures 1A-8B * | 1-10 | |

The present search report has been drawn up for all claims

| Place of search | Date of completion of the search | Examiner |
|---|---|---|
| The Hague | 9 December 2021 | But, Gabriela-Ileana |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 30 5883

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2021

| Patent document cited in search report | Publication date | Patent family member(s) | | Publication date |
|---|---|---|---|---|
| US 2009078949 A1 | 26-03-2009 | AT | 398836 T | 15-07-2008 |
| | | CN | 101061591 A | 24-10-2007 |
| | | EP | 1815532 A1 | 08-08-2007 |
| | | JP | 2008521233 A | 19-06-2008 |
| | | TW | I400816 B | 01-07-2013 |
| | | US | 2009078949 A1 | 26-03-2009 |
| | | WO | 2006054203 A1 | 26-05-2006 |
| GB 1580564 A | 03-12-1980 | CH | 618000 A5 | 30-06-1980 |
| | | DE | 2629641 A1 | 12-01-1978 |
| | | ES | 459135 A1 | 01-04-1978 |
| | | FR | 2356890 A1 | 27-01-1978 |
| | | GB | 1580564 A | 03-12-1980 |
| | | IL | 52340 A | 30-05-1980 |
| | | IT | 1085488 B | 28-05-1985 |
| | | JP | S535441 A | 19-01-1978 |
| | | JP | S5934263 B2 | 21-08-1984 |
| | | US | 4146790 A | 27-03-1979 |
| WO 2014155227 A1 | 02-10-2014 | CN | 105074944 A | 18-11-2015 |
| | | EP | 2979309 A1 | 03-02-2016 |
| | | JP | 2016521437 A | 21-07-2016 |
| | | US | 2016079490 A1 | 17-03-2016 |
| | | WO | 2014155227 A1 | 02-10-2014 |
| WO 2007122543 A2 | 01-11-2007 | CN | 101431934 A | 13-05-2009 |
| | | EP | 2012652 A2 | 14-01-2009 |
| | | JP | 5329392 B2 | 30-10-2013 |
| | | JP | 2009535081 A | 01-10-2009 |
| | | US | 2009244923 A1 | 01-10-2009 |
| | | US | 2014062336 A1 | 06-03-2014 |
| | | WO | 2007122543 A2 | 01-11-2007 |
| WO 2006104907 A1 | 05-10-2006 | CN | 101151908 A | 26-03-2008 |
| | | EP | 1864504 A1 | 12-12-2007 |
| | | JP | 2008536266 A | 04-09-2008 |
| | | KR | 20070116029 A | 06-12-2007 |
| | | TW | 200702597 A | 16-01-2007 |
| | | US | 2006227570 A1 | 12-10-2006 |
| | | WO | 2006104907 A1 | 05-10-2006 |

EPO FORM P0459

For more details about this annex : see Official Journal of the European Patent Office, No. 12/82

## REFERENCES CITED IN THE DESCRIPTION

**Non-patent literature cited in the description**

- **BARBET, ADRIEN et al.** Light-emitting diode pumped luminescent concentrators: a new opportunity for low-cost solid-state lasers. *Optica,* 2016, vol. 3 (5), 465-468
- **A. BARBET et al.** LED pumped luminescent concentrators: a new opportunity for low cost solid-state lasers. *Optica,* April 2016, vol. 3 (5), 465-468
- **D. K. G. DE BOER et al.** High-brightness source based on luminescent concentration. *Optics Express,* July 2016, vol. 24 (14), A1069

- **SATHIAN, J. et al.** Solid-state source of intense yellow light based on a Ce:YAG luminescent concentrator. *Optics Express,* June 2017, vol. 25 (12), 13714
- **CHRISTOPH HOELEN et al.** Progress in extremely high brightness LED-based light sources. *Sixteenth International Conference on Solid State Lighting and LED-based Illumination Systems, Proc. of SPIE,* vol. 10378, 103780N
- **JUNA SATHIAN et al.** Enhancing Performance of Ce:YAG Luminescent Concentrators for High Power Applications. *CLEO Europe 2019 paper CD'-P.2,* 2019